# EUROPEAN PATENT SPECIFICATION

(11) **EP 2 876 683 B1**
(45) Date of publication and mention of the grant of the patent: **10.05.2017**
(21) Application number: 14179847.0
(22) Date of filing: 05.08.2014
(51) Int. Cl.: H01L 27/32, G09G 3/32

(54) **Organic light emitting display apparatus and method of repairing the same**
Organische lichtemittierende Anzeigevorrichtung und Verfahren zur Reparatur davon
Appareil d'affichage électroluminescent organique et son procédé de réparation

(30) Priority: 20.11.2013 KR 20130141476
(43) Date of publication of application: 27.05.2015
(73) Proprietor: Samsung Display Co., Ltd., Gyeonggi-do (KR)
(72) Inventor: Kim, Dong-Kyu, Yongin-City (KR); Kim, Ki-Wook, Yongin-City (KR)
(74) Representative: Gulde & Partner

(56) References cited:
- EP-A1- 2 535 888
- US-A- 6 014 191
- US-A1- 2007 029 615
- US-A1- 2012 092 306
- US-B1- 6 327 007

## Description

### CROSS-REFERENCE TO RELATED APPLICATION

This application claims priority to and the benefit of Korean Patent Application No. 10-2013-0141476, filed on November 20, 2013

### BACKGROUND

### 1. Field

Aspects of embodiments of the present invention relate to an organic light emitting display apparatus and a method of repairing the same.

### 2. Description of the Related Art

When a defect occurs in a certain pixel, the pixel may always emit light regardless of a scanning signal and data signal. The pixel always emitting light as described above is recognized as a bright spot, which may be easily perceived by an observer due to high visibility thereof. Accordingly, generally, a defective pixel becoming a bright spot having high visibility may be repaired to become a dim spot, such that the defective pixel may be relatively less perceptible by an observer. EP 2 535 888 A1, US 2012/0092306 A1, US 6,327,007 B1, US 2007/0029615 A1 and US 6, 014,191 are concerned with repairing displays.

### SUMMARY

Aspects of embodiments of the present invention include an organic light emitting display apparatus according to claim 1 and a method according to claim 9 of repairing the same.

Additional aspects will be set forth in part in the description which follows and, in part, will be apparent from the description, or may be learned by practice of the presented embodiments.

According to aspects of embodiments of the present invention, an organic light emitting display apparatus includes a plurality of emission pixels arranged in a matrix of a plurality of rows and a plurality of columns, wherein the emission pixels each include an organic light emitting diode (LED) and an emission pixel circuit; a plurality of dummy pixels wherein each of the dummy pixels comprises a dummy pixel circuit; a plurality of repair lines, wherein at least one of the plurality of emission pixels is coupled to at least one of the plurality of dummy pixels through one of the repair lines; and at least one auxiliary repair line coupling at least two of the plurality of repair lines. Each row includes a repair line of the repair lines, and a column of the columns includes an auxiliary repair line of the auxiliary repair lines. The emission pixels are in a display region and the dummy pixels are in a non-display region, and the non-display region is at least one of a top, a bottom, a left, or a right of the display region.

At least one organic LED of the plurality of emission pixels is coupled to one of said at least two of the plurality of repair lines. The other of at least two of the plurality of repair lines is coupled to the pixel driving circuitry of one of the dummy pixels such that the at least one organic LED can be driven using said pixel driving circuitry of said one of the plurality of dummy pixels.

Each row includes at least one of the repair lines, each column may include at least one of the auxiliary repair lines, and the at least one of the repair lines and the at least one of the auxiliary repairs line may be formed on different layers and overlap, and the organic light emitting display apparatus may further include at least one insulating layer between the at least one of the repair lines and the at least one of the auxiliary repair lines.

The repair lines and auxiliary repair lines may be perpendicular to each other.

The auxiliary repair lines may be in at least one of an upper portion or a lower portion of a display region.

Each of the emission pixels may include a plurality of sub-emission pixels, each of the dummy pixels may include a plurality of sub-dummy pixel, and one or more of the repair lines may couple the sub-emission pixels to the sub-dummy pixels.

The sub-emission pixels in each of the emission pixels may emit different colors of light, respectively, and a pixel circuit of each of the sub-dummy pixels may correspond to an emission pixel circuit of each of the sub-emission pixels, and the one or more of the repair lines may couple at least one of the plurality of sub-emission pixels to one of the plurality of sub-dummy pixels, corresponding to the sub-emission pixel.

The apparatus may further include a dummy scanning line coupled to one of the dummy pixels, and the dummy scanning line may be configured to supply a scanning signal to the one of the dummy pixels, the emission pixels may each be coupled to a respective scanning line and a respective data line, the one of the dummy pixels may be coupled to the dummy scanning line and the respective data line, and the dummy pixels and the repair lines may be formed at least one for each row.

The dummy scanning line may be configured to apply a dummy scanning signal to the one of the dummy pixels while providing a certain time difference from scanning signals applied to the emission pixels by the respective scanning line, and the data line may be configured to apply a data signal identical to that applied to an emission pixel coupled to the one of the dummy pixels by the repair line concurrently with applying the dummy scanning signal to the one of the dummy pixels.

The organic LED of at least one of the emission pixels is coupled to the emission pixel circuit of the at least one emission pixel and the organic LED of the at least one emission pixel is separated from the emission pixel circuit of the at least one emission pixel.

The emission pixel circuit of the emission pixels may further include: a first transistor configured to transmit a data signal in response to a scanning signal; a capacitor configured to store a voltage corresponding to the data signal; and a second transistor configured to transfer a driving current corresponding to the voltage stored in the capacitor to the LED.

An arrangement of the dummy pixel circuit of the dummy pixels may be identical to that of the emission pixel circuit of the emission pixels, and the emission pixels may emit at a same time.

The LED of the emission pixels may include an anode, a cathode, an emission layer between the anode and cathode, and a wiring of the emission pixel circuit coupled to the anode of the LED may be broken in an emission pixel of the emission pixels that is coupled to a repair line of the repair lines.

The apparatus may further include at least one insulating layer between a first conductive portion in contact with an anode of the LED of the emission pixels and a corresponding one of the repair lines, and between a second conductive portion in contact with a dummy pixel circuit of the dummy pixel and the corresponding one of the repair lines, and the first conductive portion of the at least one emission pixel may be electrically coupled to the corresponding one of the repair lines, and the second conductive portion of the at least one dummy pixel may be electrically coupled to the corresponding one of the repair lines.

According to aspects of embodiments of the present invention, in a method of repairing an organic light emitting display apparatus, the organic light emitting display apparatus being in accordance with claim 1, the method including: electrically isolating the LED of a first defective pixel and of a second defective pixel located in a first row from an emission pixel circuit of the first defective pixel and an emission pixel circuit of the second defective pixel, respectively; electrically coupling a first repair line corresponding to the first row to the LED of the first defective pixel; electrically coupling a second repair line corresponding to a second row to the LED of the second defective pixel; electrically coupling a first dummy pixel circuit of a first dummy pixel to the first repair line for enabling a first data signal to be applied to the first defective pixel and to the first dummy pixel, thereby supplying a first driving current corresponding to the first data signal to the LED of the first defective pixel through the first repair line; and electrically coupling a second dummy pixel circuit of a second dummy pixel to the second repair line for enabling a second data signal to be applied to the second defective pixel and the second dummy pixel, thereby supplying a second driving current corresponding to the second data signal to the LED of the second defective pixel through the second repair line.

The electrical coupling of the LED of the second defective pixel includes: electrically coupling the first repair line to the LED of the second defective pixel; and electrically coupling the first repair line to the second repair line using the at least one auxiliary repair line.

The method further includes electrically isolating a portion of the first repair line, between a position in which the first repair line is coupled to the first defective pixel and a position in which the first repair line is coupled to the second defective pixel; and electrically isolating at least one of both outer sides of a portion in the auxiliary repair line used for the first repair line and second repair line.

Each emission pixel of the emission pixels may include a conductive portion coupled to the each emission pixel and overlapped with a corresponding one of the repair lines, at least one insulating layer may be between the conductive portion and the corresponding one of the repair lines, the conductive portion of the each emission pixel may be coupled to an anode of the LED of the each emission pixel, and electrically coupling the first repair line to the LED of the first defective pixel further comprises electrically coupling a conductive portion of the first defective pixel to the first repair line.

The electrically coupling of the conductive portion of the first defective pixel to the first repair line may further include destructing a portion of the insulating layer between the conductive portion of the first defective pixel and the first repair line.

### BRIEF DESCRIPTION OF THE DRAWINGS

These and/or other aspects will become more apparent and more readily appreciated from the following description of some of the embodiments, taken in conjunction with the accompanying drawings in which:
FIG. 1 is a schematic block diagram of a display apparatus according to an embodiment of the present invention;
FIG. 2 is a schematic view illustrating an example of the display panel shown in FIG. 1;
FIG. 3 is a view illustrating a method of repairing a defective pixel by using a repair line in the display panel shown in FIG. 2;
FIGS. 4 and 5 are waveform diagrams illustrating a scanning signal and data signal supplied to the repaired display panel shown in FIG. 3;
FIG. 6 is a flowchart schematically illustrating a method of repairing a defective pixel according to an embodiment of the present invention;
FIGS. 7 to 9 are views illustrating the method of repairing the defective pixel, for example, operations 62 and 63 shown in FIG. 6;
FIGS. 10 and 11 are views illustrating a method of repairing a defective pixel according to embodiments of the present invention;
FIGS. 12 and 13 are views illustrating a display panel according to another embodiment of the present invention;
FIG. 14 is a circuit diagram illustrating an emission pixel according to an embodiment of the present invention;
FIG. 15 is a view schematically illustrating a method of repairing an emission pixel using a dummy pixel according to an embodiment of the present invention;
FIG. 16 is a view illustrating a dummy pixel according to an embodiment of the present invention;
FIG. 17 is a top view illustrating a portion of the dummy pixel of FIG. 16;
FIG. 18 is a cross-sectional view illustrating a portion taken along the line B-B' shown in FIG. 17;
FIG. 19 is a cross-sectional view illustrating a repair of an emission pixel in an organic light emitting display apparatus according to an embodiment of the present invention; and
FIG. 20 is a cross-sectional view illustrating a connection of a dummy pixel in an organic light emitting display apparatus according to an embodiment of the present invention.

### DETAILED DESCRIPTION

Because the present invention may have various modifications and several embodiments, example embodiments are shown in the drawings and will be described in some detail. Aspects, features, and a method of achieving the same will be specified with reference to embodiments described below in detail together with the attached drawings. However, the embodiments may have different forms and should not be construed as being limited to the descriptions set forth herein.

Hereinafter, the embodiments of the present invention will be described in some detail with reference to the attached drawings, in which like reference numerals refer to like elements and a repetitive explanation thereof will be omitted.

It will be understood that although the terms "first", "second", etc. may be used herein to describe various components, these components should not be limited by these terms. These components are only used to distinguish one component from another. As used herein, the singular forms "a," "an", and "the" are intended to include the plural forms as well, unless the context clearly indicates otherwise.

In the embodiments below, it will be further understood that the terms "comprise" and/or "have" used herein specify the presence of stated features or components, but do not preclude the presence or addition of one or more other features or components. In the embodiments below, it will be understood that when a layer, region, or component is referred to as being "formed on" another layer, region, or component, it can be directly or indirectly formed on the other layer, region, or component. That is, for example, intervening layers, regions, or components may be present.

Also, for convenience of description, in the drawings, sizes of elements may be exaggerated or contracted. Sizes of elements in the drawings may be exaggerated for convenience of explanation. In other words, because sizes and thicknesses of components in the drawings are illustrated for convenience of explanation, the following embodiments are not limited thereto.

When a certain embodiment may be implemented differently, a specific process order may be performed differently from the described order. For example, two consecutively described processes may be performed substantially at the same time or performed in an order opposite to the described order. As used herein, the term "and/or" includes any and all combinations of one or more of the associated listed items. Expressions such as "at least one of," when preceding a list of elements, modify the entire list of elements and do not modify the individual elements of the list.

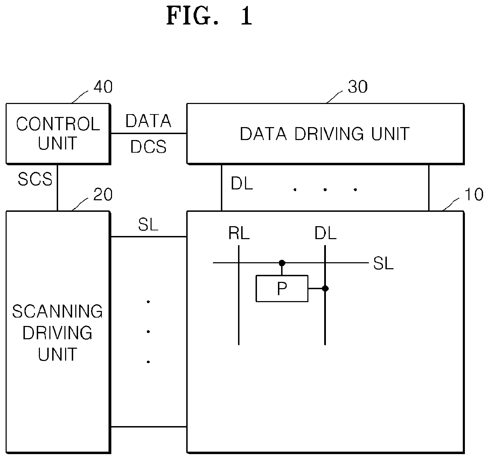

FIG. 1 is a schematic block diagram of a display apparatus 100 according to an embodiment of the present invention.

Referring to FIG. 1, the display apparatus 100 includes a display panel 10 including a plurality of pixels P, a scanning driving unit 20, a data driving unit 30, and a control unit 40. The scanning driving unit 20, data driving unit 30, and control unit 40 may be formed on individual semiconductor chips, respectively, or may be integrated on one semiconductor chip. Also, the scanning driving unit 20 may be formed on the same substrate together with the display panel 10.

In the display panel 10, a plurality of scanning lines SL are formed in a horizontal direction and a plurality of data lines DL vertically intersect with the scanning lines SL in a vertical direction. Also, in the display panel 10, a plurality of repair lines RL separated from the data lines DL extend approximately parallel thereto with a certain interval, and intersecting where the scanning lines SL are formed. On intersecting points of the pluralities of scanning lines SL, data lines DL, and repair lines RL, the plurality of pixels P arranged as an approximate matrix shape are formed.

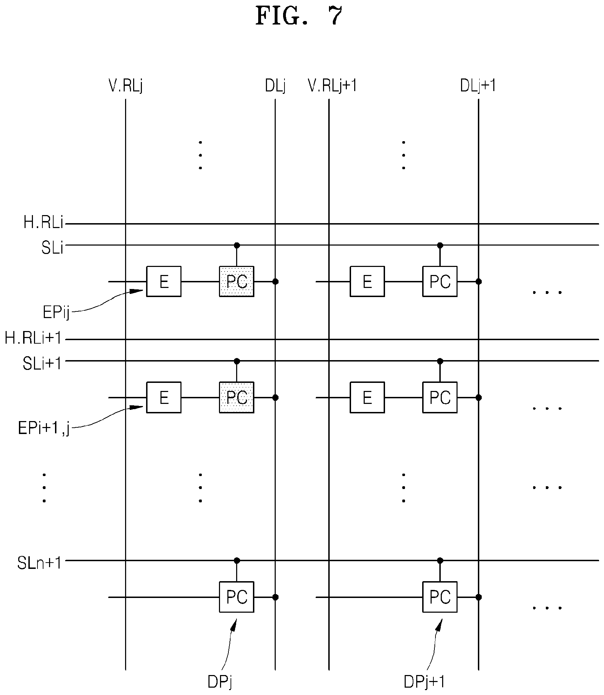

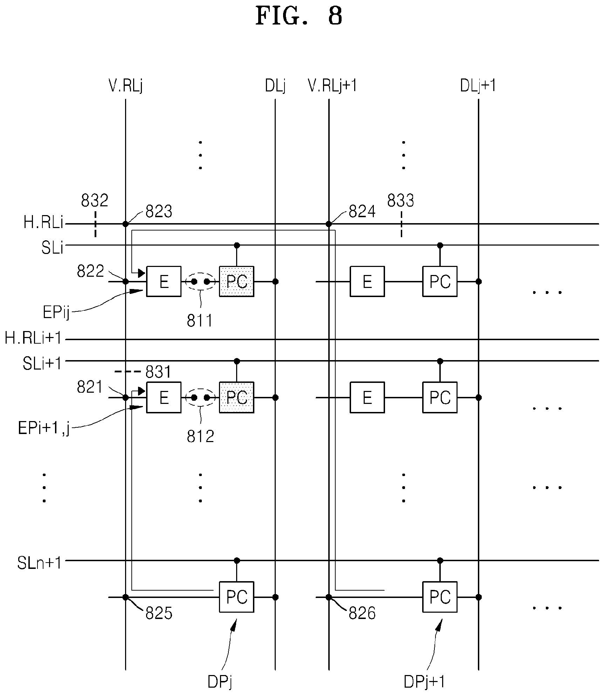

In FIG. 1, the data line DL is located on the right of the pixel P and the repair line RL is located in the left of the pixel P, but embodiments of the present invention are not limited thereto, and the relative locations of the data line DL and the repair line RL may be reversed and may be formed to include one or more for each pixel row or column. Also, the repair line RL is formed to be parallel to the data line DL and may be formed to include one or more for each pixel row according to the design of pixel. An auxiliary repair line in addition to the repair line RL may be formed to be parallel to the scanning line SL and at least one auxiliary repair line may be included in the display panel 10. It will be described below with reference to FIGS. 7 and 8. Additionally, in the display panel 10, a plurality of emission control lines supplying emission control signals, an initialization voltage line supplying an initialization voltage, and a power voltage line supplying power voltages may be additionally formed.

The scanning driving unit 20 may generate and sequentially supply scanning signals to the display panel 10 through the plurality of scanning lines SL.

The data driving unit 30 may sequentially supply data signals to the display panel 10 through the plurality of data lines DL. The data driving unit 30 converts input image data DATA having gradation, inputted from the control unit 40, into a data signal having a voltage or current shape.

The control unit 40 generates and transmits a scanning control signal SCS and data control signal DCS to the scanning driving unit 20 and the data driving unit 30, respectively. According thereto, the scanning driving unit 20 applies a scanning signal to the scanning lines SL in order (e.g., in sequential order) and the data driving unit 30 applies a data signals to the respective pixels P. A first power voltage ELVDD, a second power voltage ELVSS, an emission control signal EM, an initialization voltage Vint, or other voltage or power may be applied to the respective pixels P under the control of the control unit 40.

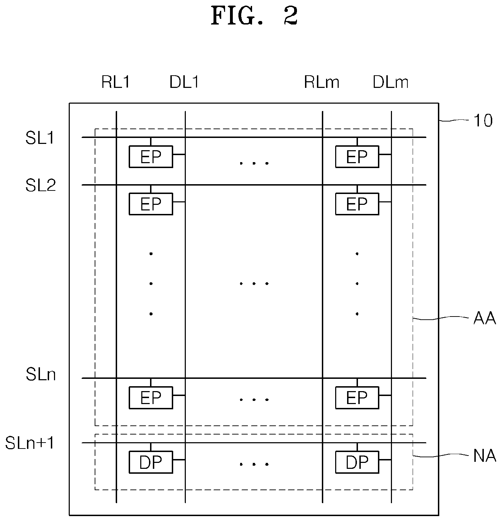

FIG. 2 is a schematic view illustrating an example of the display panel 10 shown in FIG. 1.

Referring to FIG. 2, in the display panel 10, on intersecting (e.g., overlapping) points of the pluralities of scanning lines SL, data lines DL, and repair lines RL, the plurality of pixels P are arranged as an approximate matrix shape. The pixel P includes an emission pixel EP formed in a display region AA and a dummy pixel DP formed in a non-display region NA. The non-display region NA may be formed on at least one position of top, bottom, left, or right of the display region AA. For example, one or more dummy pixels DP may be formed for each pixel row in at least one region of top and bottom of the pixel row or may be formed for each pixel column in at least one region of left and right of the pixel column. Although the dummy pixels DP are formed in the pixel row of the non-display region NA below the display region AA in FIG. 2, the dummy pixels DP may alternatively be formed in the pixel row or column of the non-display regions NA on the top, left, or right of the display region AA.

Referring to FIG. 2, the display panel 10 includes the display region AA and the non-display region NA below the display region AA. A first to nth scanning lines SL1 to SLn of a plurality of scanning lines SL1 to SLn+1 are formed in the display region AA, and an (n+1)th scanning line SLn+1, the last one, is formed in the non-display region NA. A plurality of data lines DL1 to DLm and a plurality of repair lines RL1 to RLm are formed for each pixel row in the display region AA and non-display region NA. The repair line RL may be formed to be capable of being coupled to at least one of the plurality of emission pixels EP and at least one of the dummy pixels DP.

In the display region AA, the plurality of emission pixels EP coupled to the first to nth scanning lines SL1 to SLn and the plurality of data lines DL1 to DLm, respectively, are arranged in a matrix in a plurality of rows and columns. In the non-display region NA, the plurality of dummy pixels DP connected to the (n+1)th scanning line SLn+1, the last one, and the plurality of data lines DL1 to DLm, respectively, are formed.

The control unit 40 (shown, e.g., in FIG. 1) may control a point in time when the scanning driving unit 20 of FIG. 1 applies the scanning signal to the dummy pixel DP and may control the data driving unit 30 of FIG. 1 to apply a data signal identical to a data signal applied to a defective pixel to the dummy pixel DP when the scanning signal is applied to the dummy pixel DP.

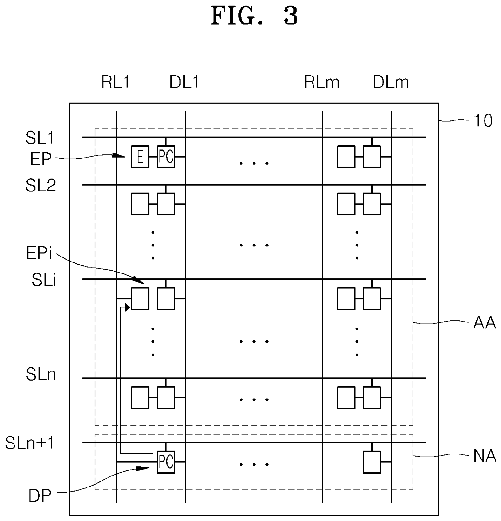

FIG. 3 is a view illustrating a method of repairing a defective pixel by using a repair line in the display panel shown in FIG. 2.

Referring to FIG. 3, the emission pixel EP formed in the display region AA may include a pixel circuit PC coupled to the scanning line SL and data line DL and a light emitting diode (LED) E receiving a driving current from the pixel circuit PC and emitting light. The dummy pixel DP formed in the non-display region NA may include only the pixel circuit PC coupled to the scanning line SL and data line DL without an LED E. However, the dummy pixel DP may include an LED according to some embodiments. When the dummy pixel DP includes the LED, the LED may not actually emit light and may function as a circuit diode or other circuit element. For example, the LED may function as a capacitor. Hereinafter, the embodiments will be described with respect to embodiments in which the dummy pixel DP includes only the pixel circuit PC. However, the dummy pixel DP is not limited thereto.

When an emission pixel EPi coupled to a scanning line SLi that is an ith of a first row is defective, an LED E of the defective emission pixel EPi is separated from the pixel circuit PC and is coupled to the pixel circuit PC of the dummy pixel DP coupled to the (n+1)th scanning line SLn+1 through the repair line RL. The separation between the LED E and the pixel circuit PC may be performed by cutting or separating a conductive portion electrically coupling the LED E and the pixel circuit PC to electrically isolate the LED E from the pixel circuit PC. The cutting of the conductive portion, for example, may be performed using a laser beam emitted toward the substrate or an opposite side of the substrate, but is not limited thereto.

An electrical coupling between the repair line RL and the LED E and an electrical coupling between the repair line RL and the dummy pixel DP may be performed by a short-circuit between two conductive portions caused by a destruction of an insulating portion or by forming the conductive portions. The destruction of the insulating portion, for example, may be performed using the laser beam emitted toward the substrate or the opposite side of the substrate but is not limited thereto.

In some embodiments, the emission pixels EP each include the conductive portion. The conductive portion may be coupled to the LED E of the emission pixel EP and may be partially overlapped with the repair line RL while arranging or forming at least one insulating layer therebetween. The conductive portion may be coupled to an anode forming the LED E of the emission pixel EP. On the other hand, the dummy pixel DP may include a conductive portion coupled to the pixel circuit PC of the dummy pixel DP and partially overlapped with the repair line RL, with at least one insulating layer located between the conductive portion of the dummy pixel DP and the repair line RL. An operation of coupling the repair line RL to the LED E and coupling the repair line RL to the dummy pixel DP may include electrically coupling the conductive portion to the repair line RL. In some embodiments, the electrically coupling the conductive portion to the repair line RL may be performed by destructing a portion of the insulating layer positioned between the conductive portion and the repair line RL.

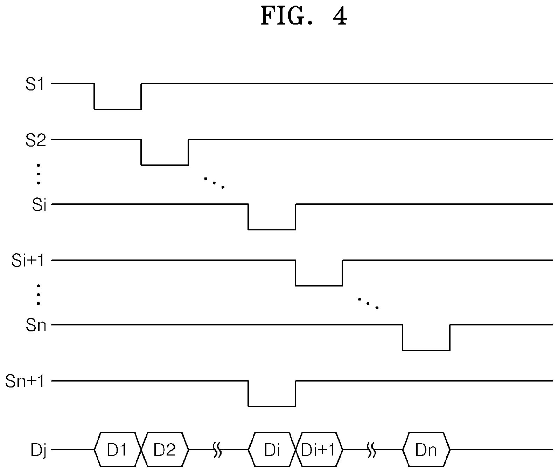

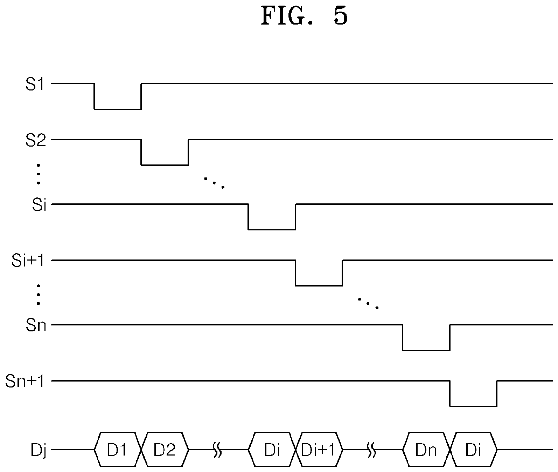

FIGS. 4 and 5 are waveform diagrams illustrating a scanning signal and data signal supplied to a repaired display panel shown in FIG. 3.

Referring to FIG. 4, the scanning driving unit 20 sequentially applies scanning signals S1 to Sn to the first to nth scanning lines SL1 to SLn and applies a scanning signal Sn+1 to the (n+1)th scanning line SLn+1 concurrently (e.g., simultaneously) with applying a scanning signal Si to the repaired emission pixel EPi.

Also, the data driving unit 30 sequentially applies data signals D1 to Dn to the data line DL while being synchronized with the respective scanning signals S1 to Sn+1. In this case, a data signal Di identical to that applied to the defective emission pixel EPi is applied to the dummy pixel DP at the same time. Accordingly, the LED E of the defective emission pixel EPi may receive a current corresponding to the data signal Di through the pixel circuit PC of the dummy pixel DP and the repair line RL. According thereto, occurrence of a bright spot or a dim spot of the defective emission pixel EPi may be reduced. A method of driving signals as described above may be applied to an embodiment, in which the defective emission pixel EPi and the dummy pixel DP coupled to the LED E of the defective emission pixel EPi share the data line DL and receive the same data signal.

Referring to FIG. 5, the scanning driving unit 20 sequentially applies the scanning signals S1 to Sn+1 to the first to (n+1)th scanning lines SL1 to SLn+1. The scanning signal Sn+1 applies an on-level to the dummy pixel DP while providing a certain time difference from on-level signals of the scanning signals S1 to Sn applied to the plurality of emission pixels EP.

Also, the data driving unit 30 sequentially applies data signals D1 to Dn to the data line DL while being synchronized with the respective scanning signals S1 to Sn+1. In this case, the data signal Di identical to that applied to the defective emission pixel EPi is applied to the dummy pixel DP again. According thereto, the LED E of the defective emission pixel EPi may receive a current corresponding to the data signal Di through the pixel circuit PC of the dummy pixel DP and the repair line RL. According thereto, occurrence of a bright spot or a dim spot of the defective emission pixel EPi may be reduced.

A method of driving signals as described above may be applied not only to embodiments in which the defective emission pixel EPi and the dummy pixel DP coupled to the LED E of the defective emission pixel EPi share the data line DL and receive the same data signal, but also to embodiments in which data signals are received from different data lines DL.

Hereinafter, for convenience of description, the embodiments will be described based on the method of FIG. 5. However, the embodiments are not limited to the method of FIG. 5. The method of FIG. 4 may also be applied and various driving methods not shown in the drawings may be applied. It may be known to a person with ordinary skill in the art that the embodiments to be described below in some detail may be applied while being variously modified according to a driving method.

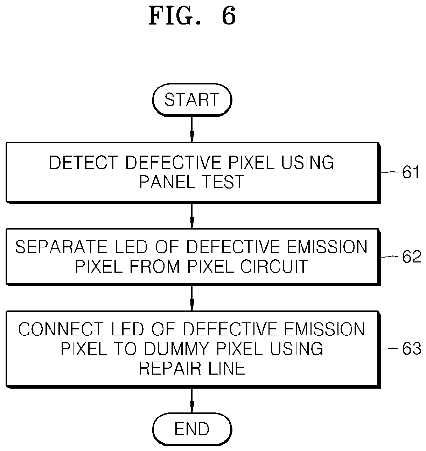

In FIGS. 4 and 5, a width of a scanning signal is shown as 1 horizontal time 1 H but it is possible to apply the width of the scanning signal as two horizontal times 2H while overlapping widths of adjacent scanning signals, for example, a width of an (n-1)th scanning signal Sn-1 and a width of the nth scanning signal Sn with each other as the 1 horizontal time 1 H or less. According thereto, a lack of charge according to an RC delay of a signal line caused by enlarging the display region AA may be overcome. FIG. 6 is a flowchart schematically illustrating a method of repairing a defective pixel according to an embodiment of the present invention.

Referring to FIG. 6, in operation 61, after the display panel 10 is completed, a defective pixel in the display region AA is detected using a panel test for the display panel 10. The panel test may include a lighting test and an aging test. The defective pixel is an emission pixel recognized as a bright spot or dim spot. The bright spot or dim spot may occur due to a defect of a pixel circuit.

A pixel of the display panel 10, viewed as the bright spot or dim spot, may be detected by an optical microscope of a lighting test apparatus.

In operation 62, an LED of the emission pixel having the bright spot or dim spot, which is a defective pixel, is separated from a pixel circuit.

In operation 63, the LED of the defective pixel is coupled to the repair line RL and a pixel circuit of a dummy pixel is coupled to the repair line RL, thereby coupling the defective pixel to the dummy pixel (S23) and determining whether the defective pixel is normalized or not.

FIGS. 7 to 9 are views illustrating the method of repairing the defective pixel, particularly, the operations 62 and 63 shown in FIG. 6.

The repair method shown in FIGS. 7 to 9 will be described based on a case, in which a dummy pixel DP is coupled to an (n+1)th scanning line SLn+1 of a plurality of scanning lines SL1 to SLn+1 as the display panel 10 of FIG. 2. However, the embodiment is not limited thereto but may be identically applied to a method of repairing a display panel, in which the dummy pixel DP is coupled to a first scanning line SL0 of a plurality of scanning lines SL0 to SLn or is coupled to a first scanning line SL0 and an (n+1)th scanning SLn+1 of a plurality of scanning lines SL0 to SLn+1.

FIG. 7 illustrates a case, in which a first emission pixel EPij and a second emission pixel EP(i+1)j of a jth row are detected as defective. The defective emission pixels may be caused by a defect of a pixel circuit.

Referring to FIG. 7, an emission pixel EP may include a pixel circuit PC coupled to a scanning line SL and data line DL and an LED E receiving a driving current from the pixel circuit PC and emitting light. A dummy pixel DP may include only the pixel circuit PC coupled to the scanning line SL and data line DL without the LED E.

Referring to FIG. 7, the dummy pixel DP may be formed at least one for each pixel row, a repair line V.RL formed in a vertical direction (hereinafter, referred to as a main repair line) may be formed at least one for each pixel row, and a repair line H.RL formed in a horizontal line (hereinafter, referred to as an auxiliary repair line) may be formed at least one for each pixel column. The auxiliary repair line H.RL may be formed to couple at least two main repair lines V.RL and may be used for coupling the main repair lines V.RL while repairing. The auxiliary repair line H.RL may form an electric path from a defective pixel in a certain row to a dummy pixel in another row by coupling the main repair lines V.RL.

On the other hand, in some embodiments, directions of the main repair line V.RL and the auxiliary repair line H.RL may be reversed. For example, when a non-display region NA is formed on the left or right of a display region AA and a dummy pixel is formed in the non-display region NA, a main repair line V.RL coupling the dummy pixel and a defective pixel may be formed in a horizontal direction and an auxiliary repair line H.RL coupling different main repair lines V.RL may be formed in a vertical direction. However, hereinafter, the embodiments will be described based on the directions shown in FIG. 7.

The main repair line V.RL and the auxiliary repair line H.RL may be formed on different layers while arranging or forming at least one insulating layer therebetween. The main repair line V.RL and the auxiliary repair line H.RL may be formed to intersect each other, for example, to be perpendicular to each other. The main repair line V.RL and the auxiliary repair line H.RL may be electrically coupled by destructing the insulating layer at an intersection between the main repair line V.RL and the auxiliary repair line H.RL. In order to electrically couple the main repair line V.RL and the auxiliary repair line H.RL, the method of coupling the conductive portion to the repair line RL, described above, may be identically applied.

FIG. 8 illustrates a case, in which a plurality of emission pixels in one row are defective. For example, there is shown a repairing method applied when a first emission pixel EPij coupled to an ith scanning line SLi of a jth row and a second emission pixel EP(i+1)j coupled to an (i+1)th scanning line SLi+1 of the jth row are defective. Referring to FIG. 8, an LED E of the first emission pixel EPij is separated from a pixel circuit PC and the separated emission diode E is coupled to a pixel circuit PC of a dummy pixel DPj+1 of a (j+1)th column coupled to an (n+1)th scanning line SLn+1 through a main repair line V.RLj, an auxiliary repair line H.RLi, and a main repair line V.RL(j+1). For example, the LED E of the first emission pixel EPij is coupled to a first main repair line V.RLj, the dummy pixel DPj+1 is coupled to a second main repair line V.RLj+1, and the first main repair line V.RLj and second main repair line V.RLj+1 are coupled to each other using an auxiliary repair line H.RLi.

In FIG. 8, it is shown that the dummy pixel DPj+1 in a (j+1)th row is used in order to repair the first emission EPij. However, the embodiment is not limited thereto and a dummy pixel in another row may be used.

An LED E of the second emission pixel EP(i+1)j is separated from a pixel circuit PC and the separated emission diode E is coupled to a pixel circuit PC of a dummy pixel DPj of a jth row coupled to an (n+1)th scanning line SLn+1 through a main repair line V.RLj.

According to the repairing method as described above, not only when one defective pixel is detected in one row, the defective pixel may be repaired using a dummy pixel in a corresponding row, but also when a plurality of defective pixels are detected in one row, the plurality of defective pixels may be repaired using corresponding dummy pixels formed in other rows.

For this, the auxiliary repair line H.RL and the main repair line V.RL may be properly used. For example, in order to couple the first defective pixel EPij located in the jth row to the dummy pixel DPj+1 located in the (j+1)th row, the main repair line V.RLj and the main repair line V.RLj+1 may be coupled. In order to couple the main repair line V.RLj to the main repair line V.RLj+1, the auxiliary repair line H.RLi may be used. The main repair line V.RL and the auxiliary repair line H.RL may be electrically coupled at intersections 823 and 824. The auxiliary repair line H.RLi, to form the electric path from the LED E of the first emission pixel EPij in the jth row to the dummy pixel DPj+1 in the (j+1)th row, couples the main repair line V.RLj to the main repair line V.RLj+1.

On the other hand, the main repair line V.RLj in the jth row is used to repair the plurality of defective pixels EPij and EP(i+1)j in the jth row. Accordingly, in the main repair line V.RLj, a portion of forming a path between the first emission pixel EPij and the dummy pixel DPj+1 and a portion of forming a path between the second emission pixel EP(i+1)j and the dummy pixel DPj are separated from each other, thereby allowing the respective paths to independently transmit signals. For this, a portion outside the used portions of the main repair line V.RLj may be cut off. For example, an outer portion 831 of portions 821 to 825 used for forming the path between the second emission pixel EP(i+1)j and the dummy pixel DPj may be cut off.

As a same reason as described above, also in the case of the auxiliary repair line H.RLi, outer portions 832 and 833 of the portion used for forming the path between the first emission pixel EPij and the dummy pixel EPj+1 may be cut off. According thereto, other portions of the auxiliary repair line H.RLi may be used to repair another defective pixel.

The separation between the LED E and the pixel circuit PC may be performed by cutting off conductive portions 811 and 812. The cutting off, for example, may be performed using a laser beam emitted toward a front side of the substrate or an opposite side of the substrate but is not limited thereto. Connections 821 and 822 between the repair line RL and the LED E, connections 825 and 826 between the repair line RL and the dummy pixel DP, and connections 823 and 824 may be performed by a short-circuit between two conductive portions caused by a destruction of an insulating portion or forming the conductive portions. The destruction of the insulating portion, for example, may be performed using the laser beam emitted toward a front side of the substrate or the opposite side of the substrate but is not limited thereto.

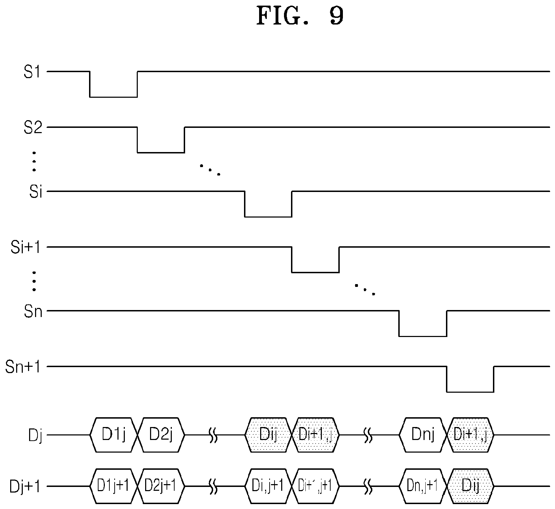

FIG. 9 is a waveform diagram illustrating scanning signals supplied from a scanning driving unit and data signals supplied form a data driving unit in the display panel repaired using the methods shown in FIGS. 7 and 8.

Referring to FIG. 9, scanning signals S1 to Sn+1 are sequentially applied to first to last scanning lines SL1 to SLn+1.

While being synchronized with the scanning signals S1 to Sn+1, data signals Dj and Dj+1 are applied to respective data lines DLj and DLj+1. To the data line DLj, data signals D1j to Dnj are sequentially applied while being synchronized with the scanning signals. To the data line DLj+1, data signals D1(j+1) to Dn(j+1) are sequentially applied while being synchronized with the scanning signals.

A data signal Dij identical to that applied to a first emission pixel EPij is applied to a dummy pixel DPj+1 again through the data line DLj+1 while being synchronized with the scanning signal Sn+1. According thereto, an LED E of the first emission pixel EPij may receive a current corresponding to a data signal Dij through a pixel circuit PC of a dummy pixel DPj+1 and main repair lines V.RLj and V.RLj+1 and an auxiliary repair line H.RLi.

A data signal D(i+1)j identical to that applied to the second emission pixel EP(i+1)j is applied to a dummy pixel DPj again through the data line DLj while being synchronized with the scanning signal Sn+1. According thereto, an LED E of the second emission pixel EP(i+1)j may receive a current corresponding to a data signal D(i+1)j through the pixel circuit PC of the dummy pixel DPj and the main repair line V.RLj.

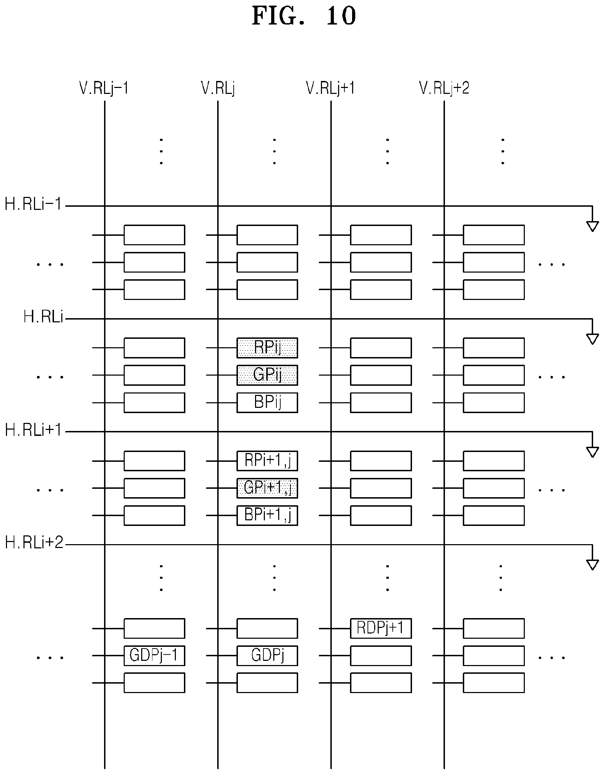

In FIGS. 7 and 8, it is shown that the main repair line V.RL is formed on the left of each row, the data line DL is formed on the right of each row, and the scanning line SL and auxiliary repair line H.RL are formed on a top of each column. However, it is just an example for convenience of description and the embodiments are not limited thereto. In FIGS. 7 and 8, the auxiliary repair line H.RL is formed for each pixel column. However, the embodiments are not limited thereto. For example, the auxiliary repair line H.RL may be formed at least one for each of some pixel columns. Otherwise, the auxiliary repair line H.RL may be formed at least one overall the display panel. The auxiliary repair line H.RL may be formed as an appropriate number in appropriate positions according to a design for wiring of the display panel. A modification as described above will be described with reference to FIGS. 10 to 13.

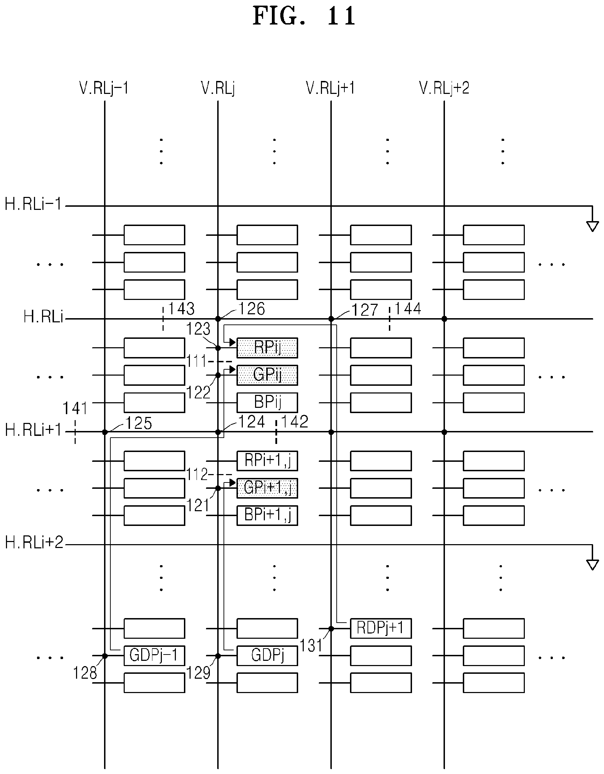

FIGS. 10 and 11 are views illustrating a method of repairing a defective pixel according to embodiments of the present invention.

In FIGS. 10 and 11, for convenience of description, scanning lines and data lines coupled to an emission pixel EP and dummy pixel DP are omitted and only repair lines V.RL and H.RL are shown. However, like the method shown in FIG. 7, it may be known to those skilled in the art that scanning lines and data lines may be coupled to the emission pixel EP and dummy pixel DP of FIGS. 10 and 11.

Referring to FIG. 10, the emission pixel EP may include a plurality of sub-emission pixels RP, GP, and BP. Each of the sub-emission pixels emits one color, for example, one of red, blue, green, and white. However, the embodiments are not limited thereto and the sub-emission pixel may emit a different color in addition to the red, blue, green, and white.

Sub-emission pixels RPij, GPij, and BPij included in an emission pixel EPij may receive identical scanning signal Si and may receive separate data signals from separate data lines, respectively.

According to some embodiments, the dummy pixel DP also includes a plurality of sub-dummy pixels RDP, GDP, and BDP. The respective sub-dummy pixels RDP, GDP, and BDP may receive identical scanning signals Sn+1 and may receive separate data signals from separate data lines, respectively. However, according to a design for scanning lines, the respective sub-dummy pixels may receive different scanning signals.

Each of the plurality of sub-emission pixels may include pixel circuits having different structures. The plurality of sub-dummy pixels may include pixel circuits corresponding to the pixel circuits of the plurality of sub-emission pixels.

The main repair line V.RL may couple at least one of the plurality of sub-emission pixels RP, GP, and BP and at least one of the plurality of sub-dummy pixels RPij, GPij, and BPij to one another. For example, the main repair line V.RL may couple at least one of the plurality of sub-emission pixels RP, GP, and BP to one of the plurality of sub-dummy pixels RPij, GPij, and BPij, having a pixel circuit corresponding to the at least one sub-emission pixel. An example as described above is shown in FIG. 11. In this case, a coupling between the main repair lines V.RL and an auxiliary repair line H.RL may be used.

Referring to FIG. 10, when being not used, the auxiliary repair line H.RL may be coupled to global power. According thereto, an error caused by a floating state may be prevented or reduced. The global power, for example, may be a first power voltage ELVDD but is not limited thereto.

FIG. 10 illustrates a case, in which emission pixels RPij, GPij, and GP(i+1)j in an jth row are detected as defective. The defectives may be caused by a defect of a pixel circuit.

FIG. 11 illustrates a repairing method applied when the emission pixels RPij, GPij, and GP(i+1)j in an ith row are detected as defective. Referring to FIG. 11, the auxiliary repair line H.RL and the main repair line V.RL may be properly used.

Referring to FIG. 11, the emission pixel GP(i+1)j, in which a defect occurs, is coupled to a dummy pixel GDPj through a main repair line V.RLj. For example, an LED E of the emission pixel GP(i+1)j is separated from a pixel circuit PC and the separated LED E is coupled to the main repair line V.RLj (121) and the dummy pixel GDPj is coupled to the main repair line V.RLj (129).

The emission pixel GPij is coupled to a dummy pixel GDPj-1 through main repair lines V.RLj and V.RLj-1 and an auxiliary repair line H.RLi+1. In detail, the LED E of the emission pixel GPij is separated from the pixel circuit, the separated LED E is coupled to the main repair line V.RLj (122), the main repair line V.RLj is coupled to the main repair line V.RLj-1 by using the auxiliary repair line H.RLi+1, and the main repair line V.RLj-1 is coupled to the dummy pixel GDPj-1. The repair lines may be coupled at intersections 124 and 125.

An emission pixel RPij is coupled to a dummy pixel RDPj-1 through main repair lines V.RLj and V.RLj+1 and an auxiliary repair line H.RLi. In detail, an LED E of the emission pixel RPij is separated from a pixel circuit, the separated LED E is coupled to the main repair line V.RLj, the main repair line V.RLj is coupled to the main repair line V.RLj+1 by using the auxiliary repair line H.RLi, and the main repair line V.RLj+1 is coupled to the dummy pixel RDPj+1. The repair lines may be coupled at intersections 126 and 127.

According to the repairing method as described above, when a plurality of defective pixels are detected in one row, the plurality of defective pixels may be repaired using dummy pixels formed corresponding to other rows.

Referring to FIG. 11, when a plurality of defective pixels in a jth row are repaired, a portion of the main repair line V.RLj in the jth row is cut off. Referring to FIG. 11, the main repair line V.RLj is used for repairing the plurality of emission pixels RPij, GPij, and GP(i+1)j. In this case, a portion of the main repair line V.RLj is cut off in order to separate or electrically isolate electrical paths from one another, through which respective emission pixels are coupled to dummy pixels.

For example, referring to FIG. 11, the emission pixel GP(i+1)j is coupled to a dummy pixel GDPj through the main repair line V.RLj. Also, the main repair line V.RLj below a connection point 121 of the emission pixel GP(i-1)j and the main repair line V.RLj couples the emission pixel GP(i+1)j and the dummy pixel GDPj to each other. In this case, a portion above the connection point 121 is cut off (112), thereby allowing an upper portion of the main repair line V.RLj to be used for repairing other emission pixels such as GPij and RPij.

Similarly, when repairing the emission pixel GPij, the portion above the connection point 122 is cut off (111), thereby allowing the upper portion of the main repair line V.RLj to be used for repairing another emission pixel such as RPij.

That is, when the main repair line V.RLj is used for repairing at least two defective pixels, for example, a first defective pixel and second defective pixel, a portion between a point, at which the main repair line V.RLj is coupled to the first defective pixel, and a point, at which the main repair line V.RLj is coupled to the second defective pixel is cut off, thereby separating paths from one another, in which signals are transmitted to the respective defective pixels through the main repair line V.RLj.

Similarly, although not shown in FIG. 11, outer portions on both sides of the portion of the auxiliary repair line H.RLi, used for repairing, are also cut off, thereby separating an electrical path from portions not used for repairing. For example, a left side of a connection point 126 and/or a right side of the connection point 127 are cut off, other portions of the auxiliary repair line H.RLi may be allowed to be used for repairing other defective pixels.

Referring to FIG. 11, the auxiliary repair lines H.RLi and H.RLi+1 used for repairing are electrically isolated from a power source and are not coupled to the power source any more.

When a plurality of defective pixels occur, a defective pixel and a dummy pixel may be matched with each other by a processor including a certain algorithm. Cutting points of the main repair line V.RL and auxiliary repair line H.RL, a connection point between the repair lines H.RL and V.RL, and a connection point between a pixel and the main repair line V.RL may be determined also by the processor including the certain algorithm.

In FIG. 11, for convenience of description on the repairing method, shorting among an emission pixel, a dummy pixel, and a repair line is briefly illustrated. However, while repairing a defective pixel, as shown in FIG. 8, it may be known to those skilled in the art that other repairing processes including separating, that is, cutting off a pixel circuit and an OLED may be identically performed and the described cutting off and shorting methods may be identically applied. Accordingly, although a description related to FIG. 11 is omitted, the description related to FIG. 8 may be identically applied.

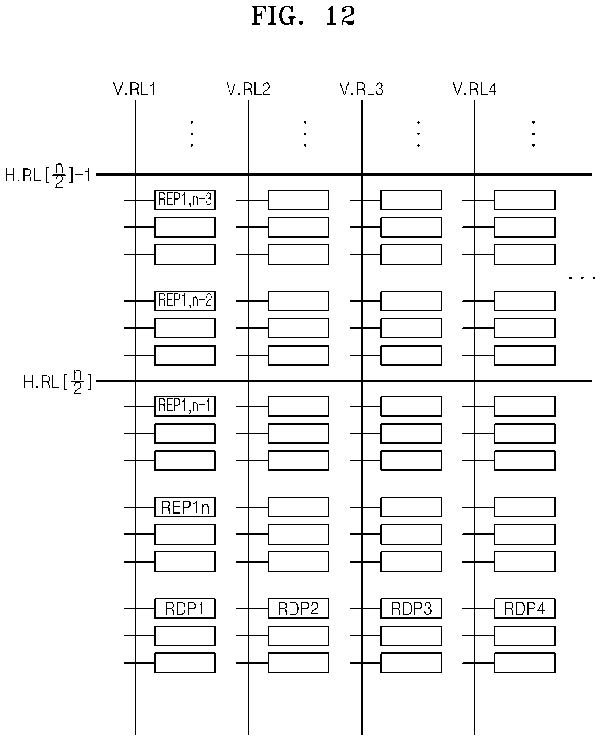

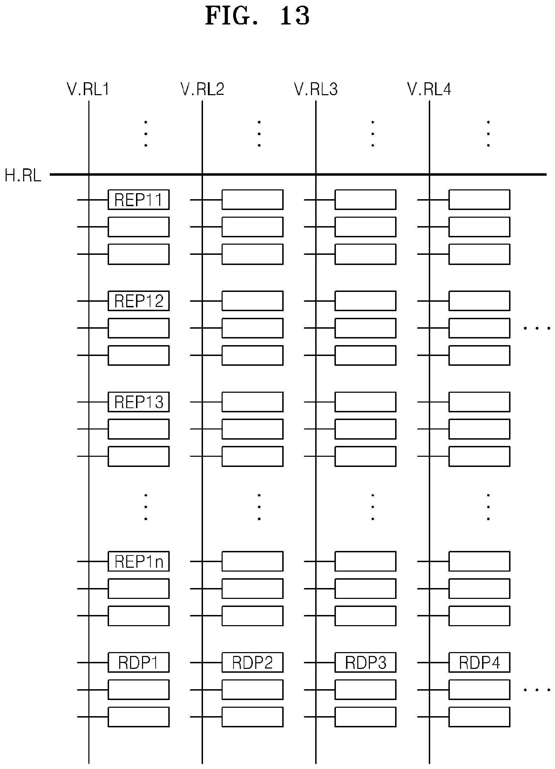

FIGS. 12 and 13 are views illustrating a display panel according to another embodiment of the present invention.

In other drawings including FIGS. 10 and 11 described above, the auxiliary repair line H.RL is formed at least one for each pixel column. Hereinafter, another example will be described with reference to FIGS. 12 and 13.

Referring to FIG. 12, the auxiliary repair line H.RL may be formed at least one for each of a plurality of pixel columns. For example, as shown in FIG. 12, at least one auxiliary repair line H.RL may be formed for each two pixel columns.

Referring to FIG. 13, the auxiliary repair line H.RL may be formed at least one in the display panel. For example, as shown in FIG. 13, dummy pixels RDP1, RDP2, RDP3, ... may be formed for each pixel row in a lower portion of the display panel and the auxiliary repair line H.RL may be formed at least one in an upper portion of the display panel. However, the embodiments are not limited thereto, dummy pixels may be formed in the upper portion of the display panel and the auxiliary repair line H.RL may be formed at least one in the lower portion of the display panel.

Referring to FIGS. 12 and 13, when a plurality of defective pixels occur in one row, the plurality of defective pixels are coupled to different dummy pixels by using the auxiliary repair line H.RL and the main repair line V.RL, thereby repairing the defective pixels. As shown in FIGS. 12 and 13, it may be determined in designing the wiring how to arrange the auxiliary repair line H.RL. For example, in order to satisfy specifications of the display panel such as aperture ratio of the display panel and a parasitic capacitor between wirings, a design of the auxiliary repair line H.RL may be controlled.

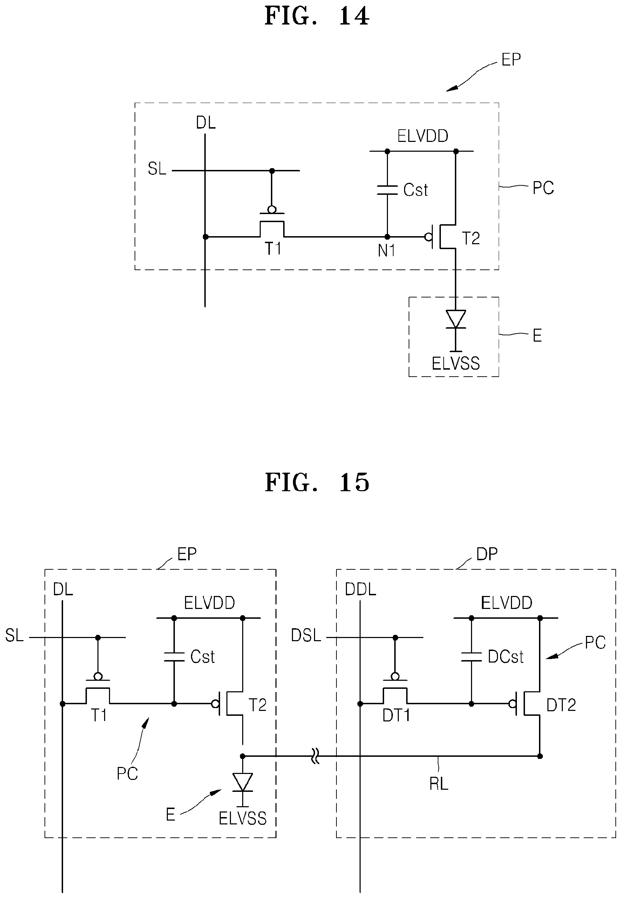

FIG. 14 is a circuit diagram illustrating an emission pixel EP according to an embodiment of the present invention.

Referring to FIG. 14, the emission pixel EP includes an LED E and an emission pixel circuit PC for supplying a current to the LED E. The LED E may be an OLED including a first electrode, a second electrode opposite to the first electrode, and an emission layer between the first electrode and second electrode. The first electrode and second electrode may be an anode and a cathode, respectively. The emission pixel circuit PC may include two transistors T1 and T2 and one capacitor Cst.

In the case of the first transistor T1, a gate electrode is coupled to a scanning line, a first electrode is coupled to a data line, and a second electrode is coupled to a first node N1.

In the case of the second transistor T2, a gate electrode is coupled to the first node N1, a first electrode receives a first power voltage ELVDD from a first power source, and a second electrode is coupled to a pixel electrode of the LED E.

In the case of the capacitor Cst, a first electrode is coupled to the first node N1 and a second electrode receives the first power voltage ELVDD from the first power source. The first transistor T1 transmits a data signal D supplied from a data line DL to the first electrode of the capacitor Cst when a scanning signal S is supplied from a scanning line SL. According thereto, the capacitor Cst is filled with a voltage corresponding to the data signal D and a driving current corresponding to the voltage filling the capacitor Cst is transferred to the LED E through the second transistor T2, thereby allowing the LED E to emit light.

In FIG. 14, there is shown a 2Tr-1 Cap structure, in which two transistors and one capacitor are included in one pixel. However, the embodiment is not limited thereto. Accordingly, two or more thin film transistors (TFTs) and one or more capacitors may be included in one pixel. Additional wirings may be further formed and existing wiring may be omitted to be formed to have various structures.

FIG. 15 is a view schematically illustrating a method of repairing an emission pixel EP using a dummy pixel DP according to an embodiment of the present invention. Referring to FIG. 15, the emission pixel EP includes an LED E and an emission pixel circuit PC for supplying a current to the LED E. The emission pixel EP of FIG. 15 may be identical to the emission pixel EP of FIG. 14. Accordingly, hereinafter, although there is an omitted description related to the emission pixel EP, it may be known that the contents described in relation to the emission pixel EP of FIG. 14 in the above may be identically applied to the emission pixel EP of FIG. 15.

The dummy pixel DP may be arranged in the same row or column of the emission pixel EP and includes a dummy pixel circuit PC. The dummy pixel circuit PC may be identical to or different from the emission pixel circuit PC.

The dummy pixel circuit PC may include a first dummy transistor DT1 coupled to a dummy scanning line DSL and a dummy data line, a second dummy transistor DT2 coupled between a first power voltage ELVDD and the first dummy transistor DT1, and a dummy capacitor DCst coupled between the first power voltage ELVDD and the first dummy transistor DT1. FIG. 15 illustrates an example of the dummy pixel circuit PC and the dummy pixel circuit PC is not limited thereto but may be formed to have various structures such as including one or more TFTs and capacitors and omitting a capacitor.

A dummy scanning line DSL may be identical to or separate from the scanning line SL located in the emission pixel circuit PC. A dummy data line DDL may be identical to or separate from the data line DL located in the emission pixel circuit PC.

When the emission pixel circuit PC is defective, the emission pixel circuit PC is separated from the LED E. Also, the LED E is coupled to the dummy pixel circuit PC in the same row or another row through a repair line RL. Hereby, the LED E of the emission pixel EP may receive a driving current from the dummy pixel circuit PC and may normally emit light. Separation and coupling between diodes may be performed by a cutting process using a laser beam and a welding process using a laser beam but are not limited thereto.

On the other hand, when a plurality of emission pixel circuits PC are defective, respective LEDs E of the defective pixels may be coupled to different dummy pixel circuits PC.

The embodiments are not limited certain pixel structures described above and may be applied to various pixels to allow light to be emitted with no loss of brightness by repairing a bright spot or dim spot of a defective pixel caused by a defect of a pixel circuit.

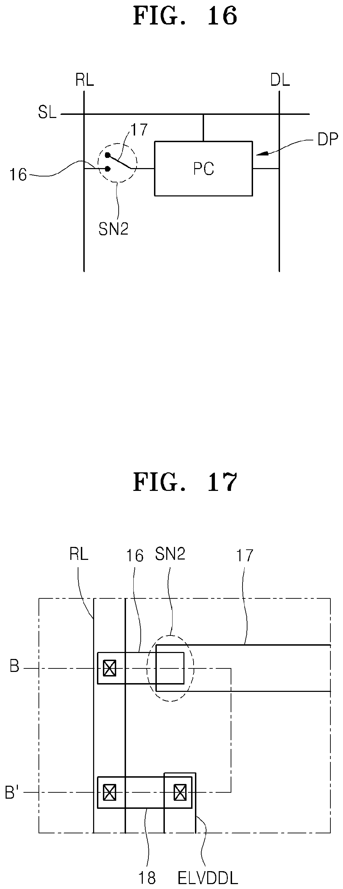

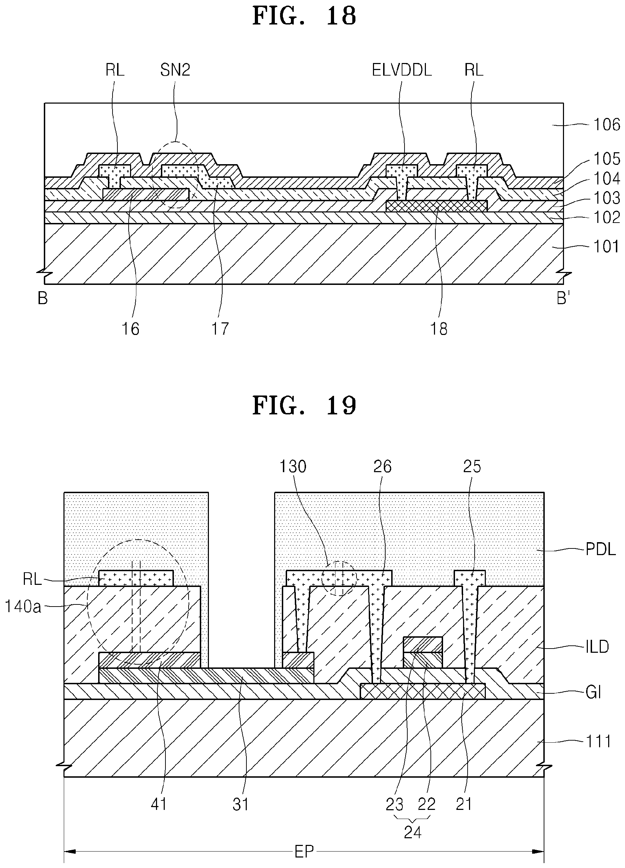

FIG. 16 is a view illustrating a dummy pixel DP according to an embodiment of the present invention. FIG. 17 is a top view illustrating a portion of the dummy pixel DP of FIG. 16. FIG. 18 is a cross-sectional view illustrating a portion taken along a line B-B' shown in FIG. 17.

Referring to FIG. 16, the dummy pixel DP coupled to 0th and/or (n+1)th scanning line SL and data line DL only includes a pixel circuit PC but does not include an LED E. The pixel circuit PC of the dummy pixel DP is identical to a pixel circuit PC of an emission pixel EP. However, as described above, the dummy pixel DP may include an LED E as a circuit diode.

Referring to FIGS. 17 and 18, a power connection wiring 18 is formed above a substrate 101 and a buffer layer 102. The power connection wiring 18, for example, may be formed of one of amorphous silicon, crystalline silicon, and an oxide semiconductor. The power connection wiring 18 may be formed of a material identical to an active layer forming a TFT of the pixel circuit PC on the same layer. A first insulating film 103 is formed above the power connection wiring 18, and a repair connection wiring 16 is formed above the first insulating film 103.

The repair connection wiring 16 may be formed of a material identical to one conductive electrode forming the TFT of the pixel circuit PC, for example, a gate electrode on the same layer. A second insulating film 104 is formed above the repair connection wiring 16. Above the second insulating film 104, a short wiring 17 coupled to the pixel circuit PC is overlapped with a portion of the repair connection wiring 16 to be provisionally coupled at a second short node SN2. A repair line RL is coupled to the repair connection wiring 16 through a contact hole.

The repair line RL and a power voltage line ELVDDL on an outer portion of the display panel 10 are coupled to the power connection wiring 18 through the contact hole, thereby electrically coupling the repair line RL and power voltage line ELVDDL to each other. When the repair line RL is used for repairing the emission pixel EP, the power voltage line ELVDDL is separated from the repair line RL by cutting off the power connection wiring 18. When being not used for repairing the emission pixel EP, the repair line RL is coupled to the power voltage line ELVDDL in parallel.

Considering this, when designing a width of the power voltage line ELVDDL, a width of the repair line RL may be considered. For example, as the width of the repair line RL, an existing width of the power voltage line ELVDDL may be reduced. An aperture ratio of a display panel may be increased and a parasitic capacitor may be reduced by reducing a width of wiring.

The repair line RL, the short wiring 17, and the power voltage line ELVDDL may be formed of a material identical to one conductive electrode forming the TFT of the pixel circuit PC, for example, a source electrode and drain electrode on the same layer. A third insulating film 105 and fourth insulating film 106 are sequentially formed above the repair line RL, the short wiring 17, and the power voltage line ELVDDL.

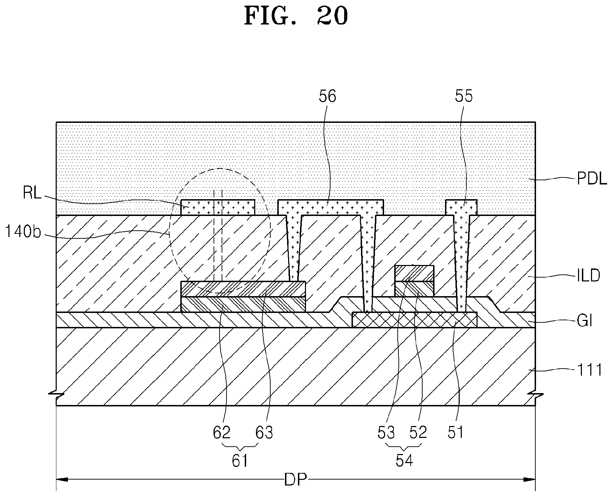

FIG. 19 is a cross-sectional view illustrating a repair of an emission pixel EP in the organic light emitting display apparatus according to an embodiment of the present invention. FIG. 20 is a cross-sectional view illustrating a connection of a dummy pixel in the organic light emitting display apparatus according to an embodiment of the present invention.

In FIGS. 19 and 20, for convenience of description, among pixel circuits of the emission pixel EP and a dummy pixel DP, only TFTs coupled to repair lines RL are shown. The embodiment shown in FIGS. 19 and 20 relates to a case of repairing after testing a vision (e.g., the display quality) of a display panel.

Referring to FIGS. 19 and 20, an active layer 21 of the TFT of the emission pixel EP and an active layer 51 of a TFT of the dummy pixel DP are formed above a substrate 111. Although not shown in the drawings, on a top surface of the substrate 111, an auxiliary layer such as a barrier layer, a blocking layer, and/or a buffer layer may be provided to prevent or reduce dispersion of ions of impurities and water or air penetration and to planarize the surface.

The active layers 21 and 51 may include a semiconductor and may include ionic impurities by doping. Also, the active layers 21 and 51 may be formed of an oxide semiconductor. The active layers 21 and 51 may include source and drain regions and channel regions, respectively. Above the substrate 111 formed with the active layers 21 and 51, a gate insulating film GI is formed.

Above the gate insulating film GI, a gate electrode 24 of the emission pixel EP and a gate electrode 54 of the dummy pixel DP are formed. The gate electrodes 24 and 54 are formed to correspond to the channel regions of the active layers 21 and 51. The gate electrodes 24 and 54 are formed by sequentially depositing and then etching a first conductive layer and second conductive layer above the gate insulating film GI. The gate electrode 54 may include first gate electrodes 22 and 52 formed of a portion of the first conductive layer and second gate electrodes 23 and 53 formed of a portion of the second conductive layer.

Also, above the gate insulating film GI, a pixel electrode 31 and a first connecting element 41 of the emission pixel EP are formed and a second connecting element 61 of the dummy pixel DP is formed. The pixel electrode 31 is formed of a portion of the first conductive layer exposed by removing a portion of the second conductive layer. The first connecting element 41 may be an extending portion extended from the pixel electrode 31 and may include portions of the first conductive layer and second conductive layer. The second connecting element 61 may include a first layer 62 formed of a portion of the first conductive layer and a second layer 63 formed of a portion of the second conductive layer. Above the substrate 111 formed with the gate electrodes 24 and 54 and the first and second connecting elements 41 and 61, an interlayer insulating film ILD is formed.

Source/drain electrodes 25/26 and 55/56 in contact with the source and drain regions of the active layers 21 and 51 through the contact hole are formed above the interlayer insulating film ILD. Also, above the interlayer insulating film ILD, the repair line RL is formed to be at least partially overlapped with the first and second connecting elements 41 and 61. A pixel defining film PDL is formed above the substrate 111 formed with the source/drain electrodes 25/26 and 55/56 and the repair line RL.

After the vision test, in an emission pixel EP detected as a defective pixel, a cutting portion 130 coupling one of the source/drain electrodes 25 and 26 coupled to the pixel electrode 31 is cut off, thereby electrically separating the TFT of the emission pixel EP from the pixel electrode 31. Accordingly, a pixel circuit of a defective emission pixel and the pixel electrode 31 are electrically separated from each other. On the other hand, in order to cut off the cutting portion 130, a laser beam may be emitted. However a method of cutting off the cutting portion 130 is not limited thereto.

In the case of a first connecting portion 140a of the emission pixel EP, shorting may be performed by destructing an insulating film. According thereto, an insulating film between the repair line RL and the first connecting element 41 is destructed and the repair line RL and the first connecting element 41 are electrically coupled to each other. Also, shorting is performed on a second connecting portion 140b of the dummy pixel DP. According thereto, an insulating film between the repair line RL and the second connecting element 61 is destructed and the repair line RL and the second connecting element 61 are electrically coupled to each other. On the other hand, in order to perform the shorting of the connecting portions 140a and 140b, laser welding may be performed by emitting a laser beam but a method of performing the shorting is not limited to the laser welding.

On the other hand, in FIGS. 19 and 20, when the cutting and shorting are performed by emitting laser beams, the laser beams may be emitted from a top or bottom of the substrate 111.

It is considered an advantageous exemplary embodiment where an organic light emitting display apparatus comprises emission pixels arranged in a matrix of rows and columns, dummy pixels and repair lines. The emission pixels each comprise a light emitting diode and at least one of the emission pixels is coupled to at least one of the dummy pixels through at least two of the repair lines and at least one auxiliary repair line coupling the at least two repair lines. Particularly a number of two or more emission pixels in a same row or in a same column may be coupled to a respective number of different dummy pixels by a respective number of different repair lines wherein one of the different repair lines is segmented in a respective number of segments, each-but-one segment being connected to a different one of the different dummy pixels through a different auxiliary repair line connecting the respective segment with a different one of the remaining different repair lines.

Before the vision test, an organic film including an emission layer and an opposite electrode are sequentially formed above the pixel electrode 31. When the organic film emits lights of red, green, and blue, respectively, the emission layer may be patterned into a red emission layer, a green emission layer, and a blue emission layer, respectively. On the other hand, when the organic film emits white light, the emission layer, to emit the white light, may have a multilayer structure, in which the red emission layer, green emission layer, and blue emission layer are deposited, or may have a single layer structure including a red emission material, green emission material, and blue emission material. The opposite electrode may be deposited on the entire surface of the substrate 111 and may be formed as a common electrode. In the embodiment, the pixel electrode 31 is used as an anode and the opposite electrode is used as a cathode. However, a polarity of an electrode may be applied reversely.

In the drawings and embodiments described above, a pixel circuit is formed as a P-channel metal oxide semiconductor (PMOS) transistor, in which a signal having a low level is an enable signal and a signal having a high level is a disable signal. However, the pixel circuit may be formed as an N-channel metal oxide semiconductor (NMOS) transistor, in which applied signals are reversed, thereby applying the driving method of the embodiment. In this case, the signal having the high level becomes an enable signal and the signal having the low level becomes the disable signal.

According to the embodiments described above, when a pixel circuit is defective, the defective pixel is repaired using a repair line, thereby improving a manufacturing yield of a display apparatus.

According to the embodiments described above, a defect of an emission pixel is repaired using a dummy pixel, thereby allowing the defective pixel to emit light at a normal point in time without changing a bright spot into a dim spot.

According to the embodiments described above, when only one main repair line is formed for each row, a plurality of defective pixels in one row may be repaired using an auxiliary repair line formed in a column direction. Because an area occupied by wirings increases in a display panel as a larger number of repair lines are formed, a limitation may be present in an aperture ratio or stability. However, according to some embodiments, because a defective pixel is repaired using a minimum repair line, a plurality of defective pixels may be effectively repaired while providing an aperture ratio and stability.

It should be understood that the example embodiments described herein should be considered in a descriptive sense only and not for purposes of limitation. Descriptions of features or aspects within each embodiment should be considered as available for other similar features or aspects in other embodiments.

While one or more embodiments of the present invention have been described with reference to the figures, it will be understood by those of ordinary skill in the art that various changes in form and details may be made therein without departing from the scope of the present invention as defined by the following claims.

## Claims

1. An display apparatus (100) comprising:
a plurality of emission pixels (EPij, EPi+1,j) arranged in a matrix of a plurality of rows and a plurality of columns, wherein the emission pixels (EPij, EPi+1,j) are in a display region (AA);a plurality of dummy pixels (DPj, DPj+1) in a non-display region (NA), which is in at least one of a top, a bottom, a left, or a right of the display region (AA);
a plurality of repair lines (V.RLj, V.RLj+1) wherein each row comprises a repair line of the repair lines; and
at least one auxiliary repair line (H.RLi) coupling to one of the plurality of repair lines (V.RLj, V.RLj+1),
**characterized in that**
the display apparatus is an organic light emitting display apparatus;
the emission pixels (EPij, EPi+1,j) each comprise an organic light emitting diode (LED)(E) and an emission pixel circuit (PC) connected to the LED (E), except at least one first emission pixel, each of the dummy pixels (DP) comprises a dummy pixel, driving circuitry (PC);
at least one first organic LED (E) of the at least one first emission pixel of the plurality of emission pixels (EPij, EPi+1,j), in which a first emission pixel circuit (PC) and the first organic LED (E) are disconnected from each other, is coupled to said one of the repair lines (V.RLⱼ, V.RLⱼ₊₁), this being coupled to the at least one auxiliary repair line (H.RLi) which is comprised by at least one of the columns and which is further coupled to one other of the plurality of repair lines (V.RLj, V.RLj+1) this being further coupled to the dummy pixel driving circuitry of one of the dummy pixels (DPj) such that the at least one first organic LED (E) can be driven using said dummy pixel driving circuitry of said one of the plurality of dummy pixels (DPj+1).

2. The apparatus of claim 1, wherein each column comprises at least one of the auxiliary repair lines (H.RLi, V.RLi+1), and
wherein the at least one (V.RLj) of the repair lines and the at least one (H.RLi) of the auxiliary repairs line are formed on different layers and overlap, wherein the organic light emitting display apparatus (100) further comprises at least one insulating layer between the at least one (V.RLj) of the repair lines and the at least one (H.RLi) of the auxiliary repair lines.

3. The apparatus of claim 2, wherein the repair lines (V.RLj, V.RLj+1) and auxiliary repair lines (H.RLi, H.RLi+1) are perpendicular to each other.

4. The apparatus of one of the preceding claims, wherein the auxiliary repair lines (H.RLi, H.RLi+1) are in at least one of an upper portion or a lower portion of a display region (AA).

5. The apparatus of one of the preceding claims, wherein each of the emission pixels (EP) comprise a plurality of sub-emission pixels (RP, GP, BP),
wherein each of the dummy pixels (DP) comprise a plurality of sub-dummy pixel (RDP, GDP, BDP), and
wherein one or more of the repair lines (V.RL) couples the sub-emission pixels (RP, GP, BP) to the sub-dummy pixels (RDP, GDP, BDP), wherein the sub-emission pixels (RP, GP, BP) in each of the emission pixels (EP) emit different colors of light, respectively, and a pixel circuit (PC) of each of the sub-dummy pixels (RDP, GDP, BDP) corresponds to an emission pixel circuit (PC) of each of the sub-emission pixels (RP, GP, BP), and
wherein the one or more of the repair lines (RL) couples at least one of the plurality of sub-emission pixels (RP, GP, BP) to one of the plurality of sub-dummy pixels (RDP, GDP, BDP), corresponding to the sub-emission pixel (RP, GP, BP).

6. The apparatus of one of the preceding claims, further comprising a dummy scanning line (SLn+1) coupled to one of the dummy pixels (DPj, DPj+1), wherein the dummy scanning line (SLn+1) is configured to supply a scanning signal to the one of the dummy pixels (DPj, DPj+1),
wherein the emission pixels (EPij) are each coupled to a respective scanning line (SLj) and a respective data line (DLi),
wherein the one of the dummy pixels (DPj) is coupled to the dummy scanning line (SLn+1) and the respective data line (DLj), and
wherein the dummy pixels (DPj, DPj+1) and the repair lines (RLj, RLj+1) are formed at least one for each row.

7. The apparatus of claim 1, wherein the LED of the emission pixels comprises an anode, a cathode, an emission layer between the anode and cathode, and
wherein a wiring (811, 812) of the first emission pixel circuit (PC) coupled to the anode of the first organic LED (E) is broken in the first emission pixel (EPij) of the emission pixels that is coupled to a repair line (RLj) of the repair lines.

8. The apparatus of one of the preceding claims, further comprising at least one insulating layer between a first conductive portion in contact with an anode of the LED (E) of the emission pixels (EP) and a corresponding one of the repair lines (V.RL), and between a second conductive portion in contact with a dummy pixel circuit (PC) of the dummy pixel (DP) and the corresponding one of the repair lines (V.RL),
wherein the first conductive portion of the at least one emission pixel (EP) is electrically coupled to the corresponding one of the repair lines (V.RL), and the second conductive portion of the at least one dummy pixel (DP) is electrically coupled to the corresponding one of the repair lines (V.RL).

9. A method of repairing the organic light emitting display apparatus (100) of claim 1, the method comprising:
electrically isolating (62) the organic LEDs (E) of a first defective pixel and of a second defective pixel located in a first row corresponding to a first repair line from an emission pixel circuit of the first defective pixel and an emission pixel circuit (PC) of the second defective pixel, respectively;
electrically coupling (61) the first repair line to the organic LED of the first defective pixel and of the second defective pixel;
electrically isolating a first from a second portion of the first repair line, between a position in which the portion of the first repair line is coupled to the organic LED of the first defective pixel and a position in which the second portion of the first repair line is coupled to the organic LED of the second defective pixel;electrically coupling the first portion of the first repair line to a second repair line corresponding to a second row using the at least one auxiliary repair line and
electrically isolating at least one of both outer sides of a portion in the auxiliary repair line used for the first repair line and second repair line thereby enabling a first data signal to be applied to the first defective pixel and to the first dummy pixel, thereby supplying a first driving current corresponding to the first data signal to the LED of the first defective pixel through the second repair line, at least one auxiliary repair line (H.RL) and the first portion of the first repair line; and enabling a second data signal to be applied to the second defective pixel and the second dummy pixel, thereby supplying a second driving current corresponding to the second data signal to the LED of the second defective pixel through the second portion of the first repair line.

10. The method of claim 9, wherein each emission pixel of the emission pixels comprise a conductive portion coupled to the each emission pixel and overlapped with a corresponding one of the repair lines, wherein at least one insulating layer is between the conductive portion and the corresponding one of the repair lines,
wherein the conductive portion of the each emission pixel is connected to an anode of the LED of the each emission pixel, and
wherein electrically coupling the first repair line to the LED of the first defective pixel further comprises electrically coupling a conductive portion of the first defective pixel to the first repair line, wherein the electrically coupling of the conductive portion of the first defective pixel to the first repair line further comprises destructing a portion of the insulating layer between the conductive portion of the first defective pixel and the first repair line.

## Patentansprüche

1. Anzeigevorrichtung (100), aufweisend:
eine Vielzahl von Emissionspixeln (EPij, EPi+1,j), die in einer Matrix aus einer Vielzahl von Zeilen und einer Vielzahl von Spalten angeordnet sind, wobei die Emissionspixel (EPij, EPi+1,j) in einem Anzeigebereich (AA) sind; eine Vielzahl von Dummy-Pixeln (DPj, DPj+1) in einem Nicht-Anzeigebereich (NA), der in zumindest einem eines oberen, eines unteren, eines linken oder eines rechten Bereichs des Anzeigebereichs (AA) ist;
eine Vielzahl von Reparaturleitungen (V.RLj, V.RLj+1), wobei jede Zeile eine Reparaturleitung der Reparaturleitungen aufweist; und
zumindest eine Hilfsreparaturleitung (H.RLi), die mit einer der Vielzahl der Reparaturleitungen (V.RLj, V.RLj+1) gekoppelt ist,
**dadurch gekennzeichnet, dass**
die Anzeigevorrichtung eine organische lichtemittierende Anzeigevorrichtung ist;
die Emissionspixel (EPij, EPi+1,j) jeweils eine organische lichtemittierende Diode (LED)(E) und eine Emissionspixelschaltung (PC), die mit der LED (E) verbunden ist, mit Ausnahme zumindest eines ersten Emissionspixels, aufweisen;
jeder der Dummy-Pixel (DP) eine Dummy-Pixel-Ansteuerschaltung (PC) aufweist;
zumindest eine erste organische LED (E) des zumindest einen ersten Emissionspixels der Vielzahl der Emissionspixel (EPij, EPi+1,j), bei dem eine erste Emissionspixelschaltung (PC) und die erste organische LED (E) voneinander getrennt sind, mit besagter einer der Reparaturleitungen (V.RLj, V.RLj+1) gekoppelt ist, wobei diese mit der zumindest einen Hilfsreparaturleitung (H.RLi) gekoppelt ist, die von zumindest einer der Spalten umfasst ist und die ferner mit einer anderen der Vielzahl der Reparaturleitungen (V.RLj, V.RLj+1) gekoppelt ist, wobei diese ferner mit der Dummy-Pixel-Ansteuerschaltung eines der Dummy-Pixel (DPj) gekoppelt ist, derart, dass die zumindest eine erste organische LED (E) mittels der besagten Dummy-Pixel-Ansteuerschaltung des besagten einen der Vielzahl der Dummy-Pixel (DPj+1) angesteuert werden kann.

2. Vorrichtung nach Anspruch 1, wobei jede Spalte zumindest eine der Hilfsreparaturleitungen (H.RLi, V.RLi+1) aufweist, und
wobei die zumindest eine (V.RLj) der Reparaturleitungen und die zumindest eine (H.RLi) der Hilfsreparaturleitungen auf verschiedenen Schichten ausgebildet sind und überlappen, wobei die organische lichtemittierende Anzeigevorrichtung (100) ferner zumindest eine Isolierschicht zwischen der zumindest einen (V.RLj) der Reparaturleitungen und der zumindest einen (H.RLi) der Hilfsreparaturleitungen aufweist.

3. Vorrichtung nach Anspruch 2, wobei die Reparaturleitungen (V.RLj, V.RLj+1) und Hilfsreparaturleitungen (H.RLi, H.RLi+1) perpendikulär zueinander sind.

4. Vorrichtung nach einem der vorhergehenden Ansprüche, wobei die Hilfsreparaturleitungen (H.RLi, H.RLi+1) in zumindest einem eines oberen Abschnitts oder eines unteren Abschnitts eines Anzeigebereichs (AA) sind.

5. Vorrichtung nach einem der vorhergehenden Ansprüche, wobei jeder der Emissionspixel (EP) eine Vielzahl von Emissions-Subpixeln (RP, GP, BP) aufweist,
wobei jeder der Dummy-Pixel (DP) eine Vielzahl von Dummy-Subpixeln (RDP, GDP, BDP) aufweist, und
wobei eine oder mehrere der Reparaturleitungen (V.RL) die Emissions-Subpixel (RP, GP, BP) mit den Dummy-Subpixeln (RDP, GDP, BDP) koppelt, wobei die Emissions-Subpixel (RP, GP, BP) in jedem der Emissionspixel (EP) jeweils verschiedene Farben von Licht emittieren und eine Pixelschaltung (PC) jedes der Dummy-Subpixel (RDP, GDP, BDP) mit einer Emissionspixelschaltung (PC) jedes der Emissions-Subpixel (RP, GP, BP) korrespondiert, und
wobei die eine oder mehrere der Reparaturleitungen (RL) zumindest einen der Vielzahl der Emissions-Subpixel (RP, GP, BP) mit einem der Vielzahl der Dummy-Subpixel (RDP, GDP, BDP), der mit dem Emissions-Subpixel (RP, GP, BP) korrespondiert, koppelt.

6. Vorrichtung nach einem der vorhergehenden Ansprüche, ferner aufweisend eine Dummy-Ansteuerleitung (SLn+1), die mit einem der Dummy-Pixel (DPj, DPj+1) gekoppelt ist, wobei die Dummy-Ansteuerleitung (SLn+1) konfiguriert ist, um ein Ansteuersignal an den einen der Dummy-Pixel (DPj, DPj+1) anzulegen,
wobei die Emissionspixel (EPij) jeweils mit einer jeweiligen Ansteuerleitung (SLj) und einer jeweiligen Datenleitung (DLi) gekoppelt sind,
wobei der eine der Dummy-Pixel (DPj) mit der Dummy-Ansteuerleitung (SLn+1) und der jeweiligen Datenleitung (DLj) gekoppelt ist, und
wobei die Dummy-Pixel (DPj, DPj+1) und die Reparaturleitungen (RLj, Rlj+1) als zumindest eine/r für jede Zeile ausgebildet sind.

7. Vorrichtung nach Anspruch 1,
wobei die LED der Emissionspixel eine Anode, eine Kathode und eine Emissionsschicht zwischen der Anode und der Kathode aufweist, und
wobei eine Verdrahtung (811, 812) der ersten Emissionspixelschaltung (PC), die mit der Anode der ersten organischen LED (E) gekoppelt ist, im ersten Emissionspixel (EPij) der Emissionspixel, der mit einer Reparaturleitung (RLj) der Reparaturleitungen gekoppelt ist, unterbrochen ist.

8. Vorrichtung nach einem der vorhergehenden Ansprüche, ferner aufweisend zumindest eine Isolierschicht zwischen einem ersten leitenden Abschnitt in Kontakt mit einer Anode der LED (E) der Emissionspixel (EP) und einer entsprechenden der Reparaturleitungen (V.RL), und zwischen einem zweiten leitenden Abschnitt in Kontakt mit einer Dummy-Pixelschaltung (PC) des Dummy-Pixels (DP) und der entsprechenden der Reparaturleitungen (V.RL),
wobei der erste leitende Abschnitt des zumindest einen Emissionspixels (EP) mit der entsprechenden der Reparaturleitungen (V.RL) elektrisch gekoppelt ist und der zweite leitende Abschnitt des zumindest einen Dummy-Pixels (DP) mit der entsprechenden der Reparaturleitungen (V.RL) elektrisch gekoppelt ist.

9. Verfahren zur Reparatur der organischen lichtemittierenden Anzeigevorrichtung (100) nach Anspruch 1, wobei das Verfahren aufweist:
elektrisches Isolieren (62) der organischen LEDs (E) eines ersten fehlerhaften Pixels und eines zweiten fehlerhaften Pixels, die in einer ersten Zeile entsprechend einer ersten Reparaturleitung angeordnet sind, jeweils von einer Emissionspixelschaltung des ersten fehlerhaften Pixels und einer Emissionspixelschaltung (PC) des zweiten fehlerhaften Pixels;
elektrisches Koppeln (61) der ersten Reparaturleitung mit der organischen LED des ersten fehlerhaften Pixels und des zweiten fehlerhaften Pixels;
elektrisches Isolieren eines ersten von einem zweiten Abschnitt der ersten Reparaturleitung zwischen einer Position, in der der Abschnitt der ersten Reparaturleitung mit der organischen LED des ersten fehlerhaften Pixels gekoppelt ist, und einer Position, in der der zweite Abschnitt der ersten Reparaturleitung mit der organischen LED des zweiten fehlerhaften Pixels gekoppelt ist; elektrisches Koppeln des ersten Abschnitts der ersten Reparaturleitung mit einer zweiten Reparaturleitung entsprechend einer zweiten Zeile mittels der zumindest einen Hilfsreparaturleitung, und
elektrisches Isolieren zumindest einer der zwei Außenseiten eines Abschnitts in der Hilfsreparaturleitung, der für die erste Reparaturleitung und die zweite Reparaturleitung verwendet wird, wodurch ein erstes Datensignal aktiviert wird, um an den ersten fehlerhaften Pixel und an den ersten Dummy-Pixel angelegt zu werden, wodurch die LED des ersten fehlerhaften Pixels durch die zweite Reparaturleitung, zumindest eine Hilfsreparaturleitung (H.RL) und den ersten Abschnitt der ersten Reparaturleitung mit einem ersten Ansteuerstrom entsprechend dem ersten Datensignal versorgt wird; und Aktiveren eines zweiten Datensignals, um an den zweiten fehlerhaften Pixel und den zweiten Dummy-Pixel angelegt zu werden, wodurch die LED des zweiten fehlerhaften Pixels durch den zweiten Abschnitt der ersten Reparaturleitung mit einem zweiten Ansteuerstrom entsprechend dem zweiten Datensignal versorgt wird.

10. Verfahren nach Anspruch 9,
wobei jeder Emissionspixel der Emissionspixel einen leitenden Abschnitt, der mit jedem Emissionspixel gekoppelt ist und mit einer entsprechenden der Reparaturleitungen überlappt, aufweist, wobei zumindest eine Isolierschicht zwischen dem leitenden Abschnitt und der entsprechenden der Reparaturleitungen ist,
wobei der leitende Abschnitt jedes Emissionspixels mit einer Anode der LED jedes Emissionspixels verbunden ist, und
wobei das elektrische Koppeln der ersten Reparaturleitung mit der LED des ersten fehlerhaften Pixels ferner elektrisches Koppeln eines leitenden Abschnitts des ersten fehlerhaften Pixels mit der ersten Reparaturleitung aufweist, wobei das elektrische Koppeln des leitenden Abschnitts des ersten fehlerhaften Pixels mit der ersten Reparaturleitung ferner Zerstören eines Abschnitts der Isolierschicht zwischen dem leitenden Abschnitt des ersten fehlerhaften Pixels und der ersten Reparaturleitung aufweist.

## Revendications

1. Appareil d'affichage (100) comprenant :
une pluralité de pixels d'émission (EPij, EPi+1,j) agencés dans une matrice d'une pluralité de rangées et d'une pluralité de colonnes, dans lequel les pixels d'émission (EPij, EPi+1,j) se trouvent dans une région d'affichage (AA) ; une pluralité de pixels fictifs (DPj, DPj+1) dans une région de non-affichage (NA), qui se trouve au moins en haut, en bas, à gauche ou à droite de la région d'affichage (AA) ;
une pluralité de lignes de réparation (V.RLj, V.RLj+1) dans laquelle chaque rangée comprend une ligne de réparation des lignes de réparation ; et
au moins une ligne de réparation auxiliaire (H.RLi) couplée à l'une de la pluralité de lignes de réparation (V.RLj, V.RLj+1),
**caractérisé en ce que**
l'appareil d'affichage est un appareil d'affichage électroluminescent organique ;
les pixels d'émission (EPij, EPi+1,j) comprennent chacun une diode électroluminescente organique (LED) (E) et un circuit de pixels d'émission (PC) relié à la LED(E), à l'exception d'au moins un premier pixel d'émission,
chacun des pixels fictifs (DP) comprend un ensemble de circuits d'attaque de pixels fictifs (PC) ;
au moins une première LED(E) organique de l'au moins un premier pixel d'émission de la pluralité de pixels d'émission (EPij, EPi+1,j), dans laquelle un premier circuit de pixels d'émission (PC) et la première LED(E) organique ne sont pas reliés l'un(e) à l'autre, est couplée à ladite ligne des lignes de réparation (V.RLj, V.RLj+1), celle-ci étant couplée à l'au moins une ligne de réparation auxiliaire (H.RLi) qui est comprise dans au moins l'une des colonnes et qui est en outre couplée à une autre de la pluralité de lignes de réparation (V.RLj, V.RLj+1) celle-ci étant en outre couplée à l'ensemble de circuits d'attaque de pixels fictifs de l'un des pixels fictifs (DPj) de sorte que l'au moins une première LED(E) organique puisse être attaquée en utilisant ledit ensemble de circuits d'attaque de pixels fictifs dudit pixel de la pluralité de pixels fictifs (DPj+1).

2. Appareil de la revendication 1, dans lequel chaque colonne comprend au moins l'une des lignes de réparation auxiliaires (H.RLi, V.RLi+1), et
dans lequel l'au moins une (V.RLj) des lignes de réparation et l'au moins une (H.RLi) des lignes de réparation auxiliaires sont formées sur des couches différentes et se chevauchent, dans lequel l'appareil d'affichage électroluminescent organique (100) comprend en outre au moins une couche isolante entre l'au moins une (V.RLj) des lignes de réparation et l'au moins une (H.RLi) des lignes de réparation auxiliaires.

3. Appareil de la revendication 2, dans lequel les lignes de réparation (V.RLj, V.RLj+1) et les lignes de réparation auxiliaires (H.RLi, H.RLi+1) sont perpendiculaires l'une à l'autre.

4. Appareil de l'une des revendications précédentes, dans lequel les lignes de réparation auxiliaires (H.RLi, H.RLi+1) se trouvent dans au moins l'une parmi une partie supérieure et une partie inférieure d'une région d'affichage (AA).

5. Appareil de l'une des revendications précédentes, dans lequel chacun des pixels d'émission (EP) comprend une pluralité de sous-pixels d'émission (RP, GP, BP),
dans lequel chacun des pixels fictifs (DP) comprend une pluralité de sous-pixels fictifs (RDP, GDP, BDP), et
dans lequel une ou plusieurs lignes des lignes de réparation (V.RL) couple/couplent les sous-pixels d'émission (RP, GP, BP) aux sous-pixels fictifs (RDP, GDP, BDP), dans lequel les sous-pixels d'émission (RP, GP, BP) dans chacun des pixels d'émission (EP) émettent, respectivement, différentes couleurs de lumière, et un circuit de pixels (PC) de chacun des sous-pixels fictifs (RDP, GDP, BDP) correspond à un circuit de pixels d'émission (PC) de chacun des sous-pixels d'émission (RP, GP, BP), et
dans lequel l'une ou les plusieurs lignes des lignes de réparation (RL) couple/couplent au moins l'un de la pluralité de sous-pixels d'émission (RP, GP, BP) à l'un de la pluralité de sous-pixels fictifs (RDP, GDP, BDP), correspondant aux sous-pixels d'émission (RP, GP, BP).

6. Appareil de l'une des revendications précédentes, comprenant en outre une ligne de balayage fictive (SLn+1) couplée à l'un des pixels fictifs (DPj, DPj+1), dans lequel la ligne de balayage fictive (SLn+1) est configurée pour fournir un signal de balayage à l'un des pixels fictifs (DPj, DPj+1),
dans lequel les pixels d'émission (EPij) sont couplés chacun à une ligne de balayage respective (SLj) et à une ligne de données respective (DLi),
dans lequel l'un des pixels fictifs (DPj) est couplé à la ligne de balayage fictive (SLn+1) et à la ligne de données (DLj) respective, et
dans lequel les pixels fictifs (DPj, DPj+1) et les lignes de réparation (RLj, RLj+1) sont formés au moins un(e) pour chaque rangée.

7. Appareil de la revendication 1, dans lequel la LED des pixels d'émission comprend une anode, une cathode, une couche d'émission entre l'anode et la cathode, et
dans lequel un câblage (811, 812) du premier circuit de pixels d'émission (PC) couplé à l'anode de la première LED(E) organique est rompu dans le premier pixel d'émission (EPij) des pixels d'émission qui est couplé à une ligne de réparation (RLj) des lignes de réparation.

8. Appareil de l'une des revendications précédentes, comprenant en outre au moins une couche isolante entre une première partie conductrice en contact avec une anode de la LED(E) des pixels d'émission (EP) et une ligne correspondante des lignes de réparation (V.RL), et entre une deuxième partie conductrice en contact avec un circuit de pixels fictifs (PC) du pixel fictif (DP) et la ligne correspondante des lignes de réparation (V.RL),
dans lequel la première partie conductrice de l'au moins un pixel d'émission (EP) est couplée électriquement à la ligne correspondante des lignes de réparation (V.RL), et la deuxième partie conductrice de l'au moins un pixel fictif (DP) est couplée électriquement à la ligne correspondante des lignes de réparation (V.RL).

9. Procédé de réparation de l'appareil d'affichage électroluminescent organique (100) de la revendication 1, le procédé comprenant le fait :
d'isoler électriquement (62) les LED(E) organiques d'un premier pixel défectueux et d'un deuxième pixel défectueux situés dans une première rangée correspondant à une première ligne de réparation à partir d'un circuit de pixels d'émission du premier pixel défectueux et d'un circuit de pixels d'émission (PC) du deuxième pixel défectueux, respectivement ;
de coupler électriquement (61) la première ligne de réparation à la LED organique du premier pixel défectueux et du deuxième pixel défectueux ;
d'isoler électriquement une première partie d'une deuxième partie de la première ligne de réparation, entre une position dans laquelle la partie de la première ligne de réparation est couplée à la LED organique du premier pixel défectueux et une position dans laquelle la deuxième partie de la première ligne de réparation est couplée à la LED organique du deuxième pixel défectueux ;
de coupler électriquement la première partie de la première ligne de réparation à une deuxième ligne de réparation correspondant à une deuxième rangée en utilisant l'au moins une ligne de réparation auxiliaire et
d'isoler électriquement au moins l'un des deux côtés extérieurs d'une partie dans la ligne de réparation auxiliaire utilisée pour le première ligne de réparation et la deuxième ligne de réparation permettant ainsi à un premier signal de données d'être appliqué au premier pixel défectueux et au premier pixel fictif, fournissant ainsi un premier courant d'attaque correspondant au premier signal de données à la LED du premier pixel défectueux à travers la deuxième ligne de réparation, au moins une ligne de réparation auxiliaire (H.RL) et la première partie de la première ligne de réparation ; et
de permettre à un deuxième signal de données d'être appliqué au deuxième pixel défectueux et au deuxième pixel fictif, fournissant ainsi un deuxième courant d'attaque correspondant au deuxième signal de données à la LED du deuxième pixel défectueux à travers la deuxième partie de la première ligne de réparation.

10. Procédé de la revendication 9, dans lequel chaque pixel d'émission des pixels d'émission comprend une partie conductrice couplée à chaque pixel d'émission et chevauchée par une ligne correspondante des lignes de réparation, dans lequel au moins une couche isolante se trouve entre la partie conductrice et une ligne correspondante des lignes de réparation,
dans lequel la partie conductrice de chaque pixel d'émission est reliée à une anode de la LED de chaque pixel d'émission, et
dans lequel le couplage électrique de la première ligne de réparation à la LED du premier pixel défectueux comprend en outre le couplage électrique d'une partie conductrice du premier pixel défectueux à la première ligne de réparation, dans lequel le couplage électrique de la partie conductrice du premier pixel défectueux à la première ligne de réparation comprend en outre la destruction d'une partie de la couche isolante entre la partie conductrice du premier pixel défectueux et la première ligne de réparation.
